# EUROPEAN PATENT APPLICATION

(11) **EP 2 175 491 A2**
(43) Date of publication of application: **14.04.2010**
(21) Application number: 09172516.8
(22) Date of filing: 08.10.2009
(51) Int. Cl.: H01L 27/32

(54) **Organic EL display apparatus**

(30) Priority: 10.10.2008 JP 2008264192; 24.09.2009 JP 2009219064
(71) Applicant: Canon Kabushiki Kaisha, Tokyo 146-8501 (JP)
(72) Inventor: Ikari, Kenichi, Tokyo Tokyo 146-8501 (JP); Tsuboyama, Akira, Tokyo Tokyo 146-8501 (JP); Suzuki, Koichi, Tokyo Tokyo 146-8501 (JP); Shiobara, Satoru, Tokyo Tokyo 146-8501 (JP); Mori, Toshifumu, Tokyo Tokyo 146-8501 (JP)
(74) Representative: Leson, Thomas Johannes Alois

(57) **Abstract**

Provided is an organic EL display apparatus which can be driven at a low voltage and in which a red-light-emitting device uses a phosphorescent material, a greenlight-emitting device uses a delayed fluorescent material, and the same material is used in the hole transport layers of the respective devices.

## Description

### BACKGROUND OF THE INVENTION

### Field of the Invention

The present invention relates to an organic EL display apparatus, and more specifically, to an organic EL display apparatus using an organic EL device having a delayed fluorescent material as a pixel.

### Description of the Related Art

In recent years, researches have been vigorously conducted on organic EL display apparatuses each using an organic EL device.

A light-emitting material for use in the organic EL device includes, for example, a fluorescent material and a phosphorescent material.

In addition, Japanese Patent Application Laid-Open No. 2004-241374 describes that a delayed fluorescent material is used in an organic EL device for improving the emission efficiency. Japanese Patent Application Laid-Open No. 2004-241374 describes that the delayed fluorescent material showed each of a strong delayed fluorescent spectrum and a strong phosphorescent spectrum within the range of 520 nm to 750 nm.

### SUMMARY OF THE INVENTION

Use of a phosphorescent material enables a red color organic EL device to emit light with high efficiency. However, a green color organic EL device or blue color organic EL device is susceptible to improvement in order that the device may be able to emit light with high efficiency.

A phosphorescent material can be theoretically expected to emit light with higher efficiency than a fluorescent material does. However, even the phosphorescent material is still susceptible to improvement in terms of green or blue light emission.

Japanese Patent Application Laid-Open No. 2004-241374 describes that the delayed fluorescent material described in the document showed each of a strong delayed fluorescent spectrum and a strong phosphorescent spectrum in the range of 520 nm to 750 nm. However, an emission wavelength actually illustrated in a figure is formed of a peak having a maximum emission wavelength in excess of 550 nm and a peak having a maximum emission wavelength in excess of 600 nm. That is, the delayed fluorescent material is not a light-emitting material capable of emitting light of a primary color such as a green or blue color in terms of its color purity.

The present invention provides an organic EL display apparatus excellent in power consumption and capable of emitting lights of three colors, i.e., red, green, and blue colors by making contrivance to a green color organic EL device which is susceptible to improvement in terms of its emission efficiency.

That is, the present invention provides an organic EL display apparatus including: an organic EL device that emits red light as a first pixel; an organic EL device that emits green light as a second pixel; and an organic EL device that emits blue light as a third pixel, in which: the organic EL device that emits red light includes a phosphorescent material in its light-emitting layer; the organic EL device that emits green light has a delayed fluorescent material in its light-emitting layer; and a hole transport layer of the organic EL device that emits red light and a hole transport layer of the organic EL device that emits green light include the same material.

According to the present invention, there can be provided an organic EL display apparatus that shows a small power consumption by using a delayed fluorescent material in an organic EL device that emits green light.

Further features of the present invention will become apparent from the following description of exemplary embodiments with reference to the attached drawings.

### BRIEF DESCRIPTION OF THE DRAWINGS

FIG. 1 is a schematic diagram illustrating an emission process for phosphorescence.

FIG. 2 is a schematic diagram illustrating an emission process for delayed fluorescence.

### DESCRIPTION OF THE EMBODIMENTS

The organic EL display apparatus according to the present invention is an organic EL display apparatus including: an organic EL device that emits red light as a pixel; an organic EL device that emits green light as a pixel; and an organic EL device that emits blue light as a pixel, in which: the organic EL device that emits red light includes a host material and a phosphorescent material as a guest material in its light-emitting layer; the organic EL device that emits green light includes a host material and a delayed fluorescent material as a guest material in its light-emitting layer; and the hole transport layer of the organic EL device that emits red light and the hole transport layer of the organic EL device that emits green light include the same material.

The organic EL device that emits red light causes the phosphorescent material to emit light. This is because the phosphorescent material emits light with high efficiency. Since the energy of red light emission is smaller than the energy of the emission of light of any other color, the S1 excited state of the host material that supplies its excitation energy to the phosphorescent material via the T1 excited states of the materials is not required to be high. The foregoing means that neither the expansion of the band gap of the host material nor the deepening (distancing from a vacuum level) of the HOMO of the host material is needed.

The term "T1 excited state" herein employed refers to the lowest excited triplet state. The term "host material" herein employed refers to a material which constitutes the light-emitting layer and has a higher weight ratio than that of the guest material. The term "guest material" herein employed refers to a material which constitutes the light-emitting layer.

On the other hand, when a phosphorescent material is used in the organic EL device that emits green light, higher energy than the energy of the red light is needed. As a result, the S1 excited state of the host material needs to be raised.

Of course, the organic EL device that emits red light and the organic EL device that emits green light are different from each other in emission color; a difference in band gap or HOMO between the host materials of both the devices is preferably as small as possible from the viewpoint of a reduction in the drive voltage of the display apparatus.

In view of the foregoing, in the present invention, the delayed fluorescent material is used as a guest material for the organic EL device that emits green light.

A fluorescent material that is not a delayed fluorescent material theoretically has lower efficiency than that of a phosphorescent material. However, since the fluorescent material emits light in its S1 excited state, i.e., its lowest excited singlet state, the S1 excited state of a host material can be made lower than the S1 excited state of a host material to be used when the phosphorescent material is used. That is, the fluorescent material has the potential to allow an organic EL device to be driven at a low voltage.

In the present invention, attention was paid to the delayed fluorescent material as a material capable of emitting light with high efficiency while being a fluorescent material.

That is, now that a phosphorescent material capable of emitting light with high efficiency is adopted for the red color and hence low voltage driving can be achieved for the organic EL device that emits red light, low voltage driving must also be achieved for an organic EL device that emits light of any other color, specifically green light. In view of the foregoing, in the present invention, the phosphorescent material has been used in the organic EL device that emits red light, and the delayed fluorescent material has been used in the organic EL device that emits green light.

With such procedure, there arises no difference in band gap or HOMO between the host materials of the organic EL devices for the both colors, so that the hole transport layers of the respective organic EL devices can be formed of the same material.

The term "hole transport layer" refers to a layer that is adjacent to the light-emitting layer and is provided on a side close to an anode.

The term "organic EL device" refers to a device having at least a pair of electrodes and organic compound layers interposed between the electrodes.

The organic compound layers of each organic EL device according to the present invention have at least a light-emitting layer and a hole transport layer. The organic compound layers may appropriately have a hole injection layer, an electron blocking layer, a hole blocking layer, an electron transport layer, or an electron injection layer in addition to the above layers.

The term "pair of electrodes" refers to an anode and a cathode. In the organic EL display apparatus according to the present invention, which has a plurality of organic EL devices, the electrodes on one side of the respective organic EL devices may be common, that is, may be made conductive with each other. That is, for example, a constitution can be adopted in which a cathode is provided in common to the multiple organic EL devices, and anodes are independently provided for the respective organic EL devices.

Examples of the delayed fluorescent material used in the present invention include a copper complex, a platinum complex, and a palladium complex. Examples of the delayed fluorescent materials, Chem 1 and Chem 2, are shown below.

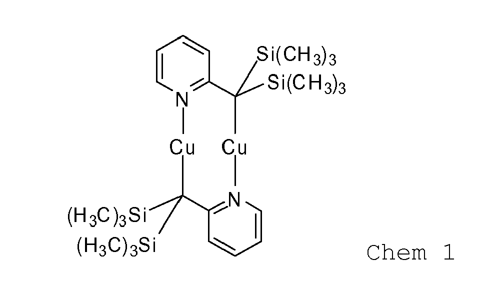

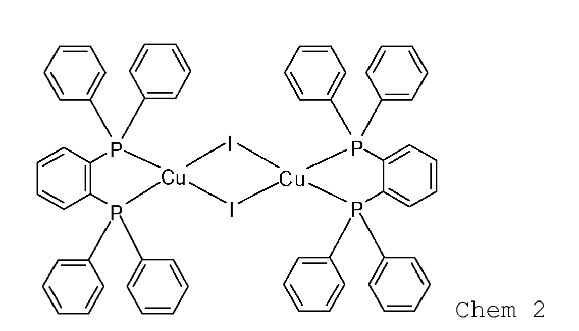

The term "delayed fluorescence" herein employed refers to thermal excitation-type delayed fluorescence. The thermal excitation-type delayed fluorescence is as follows: an exciton in its lowest excited triplet state absorbs thermal energy to be thermally excited to its lowest excited singlet state, and then the exciton emits light from its lowest excited singlet state.

When the delayed fluorescent material is used in an organic EL device, an exciton in a triplet state as well as an exciton in a 25% singlet state produced by carrier recombination undergoes intersystem crossing toward a singlet state. Accordingly, in principle, an emission yield of 100% can be expected from the device.

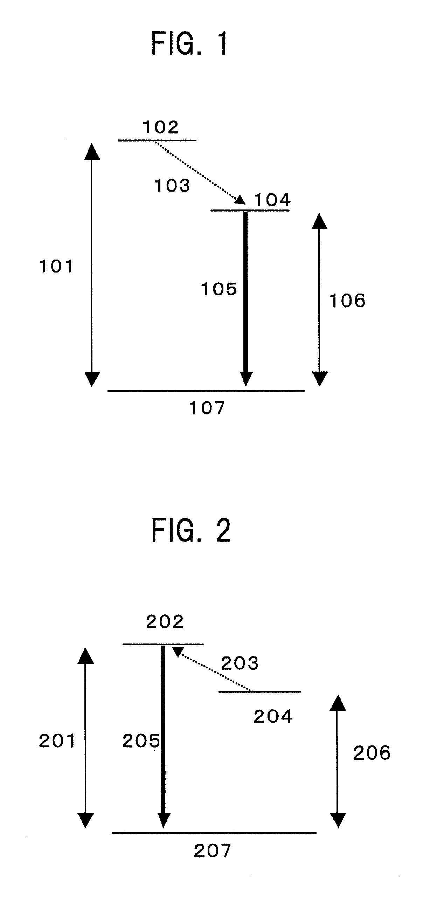

Here, the emission mechanisms for the delayed fluorescence and phosphorescence are compared with each other with reference to FIGS. 1 and 2.

First, reference numerals in the figures are described. Reference numeral 101 denotes S1 energy; 102, a lowest excited singlet state; 103, intersystem crossing; 104, a lowest excited triplet state; 105, light emission; 106, T1 energy; 107, a ground state; 201, S1 energy; 202, a lowest excited singlet state; 203, intersystem crossing; 204, a lowest excited triplet state; 205, light emission; and 206, T1 energy.

FIG. 1 is a diagram schematically illustrating the emission mechanism for phosphorescence. Of a singlet exciton in the lowest excited singlet state 102 produced by carrier recombination and a triplet exciton in the lowest excited triplet state 104, the singlet exciton undergoes the intersystem crossing 103 to be turned into the triplet exciton, and the triplet exciton undergoes a transition to the ground state 107, so that the light emission 105 occurs.

FIG. 2 is a diagram schematically illustrating the emission mechanism for the delayed fluorescence. Of a singlet exciton in the lowest excited singlet state 202 produced by carrier recombination and a triplet exciton in the lowest excited triplet state 204, the triplet exciton undergoes the intersystem crossing 203 to be turned into the singlet exciton, and the singlet exciton undergoes a transition to the ground state 207, so that the light emission 205 occurs.

Phosphorescence and the delayed fluorescence are compared with each other with reference to FIGS. 1 and 2. The length in the vertical direction of each figure is defined as the magnitude of energy, and it is assumed that light having the same wavelength is emitted in both the phosphorescence and the delayed fluorescence. It can be found by paying attention to an energy difference between the singlet exciton and the ground state (S1 energy 101 or 201) and an energy difference between the triplet exciton and the ground state (T1 energy 106 or 206) that each of the S1 energy and T1 energy of the delayed fluorescence is smaller than the corresponding one of phosphorescence (101<201 and 106<206). That is, an energy difference (energy gap) between an excited state and a ground state in the delayed fluorescence is smaller than that in phosphorescence at the same emission wavelength.

When the energy gap of a light-emitting material, i.e., a guest material in an organic EL device is small, the energy gap of a host material may be small. Accordingly, an energy difference between the energy gap and the work function of an electrode for use in an anode or cathode, the HOMO of a hole transport layer, or the LUMO of an electron transport layer becomes small, so that an injection barrier for a hole and an injection barrier for an electron become small. As a result, the drive voltage of the organic EL device is reduced. Therefore, each of the S1 energy and T1 energy of the delayed fluorescent material is smaller than the corresponding one of a phosphorescent material at the same emission wavelength, so that an injection barrier for a hole and an injection barrier for an electron become small, and hence the drive voltage of the organic EL device is reduced.

The delayed fluorescent material satisfies all of the following properties:
(1) the emission lifetime at room temperature (298 K) is at a level of microsecond;
(2) the emission wavelength at room temperature (298 K) is shorter than an emission wavelength at a low temperature (77 K);
(3) the emission lifetime at room temperature (298 K) is much shorter than an emission lifetime at the low temperature (77 K); and
(4) the emission intensity increases with increasing temperature.

In the case of fluorescence which is not the delayed fluorescence or phosphorescence, comparison between an emission wavelength at room temperature and an emission wavelength at a low temperature shows that the wavelengths are identical to each other, or the emission wavelength at the low temperature is shorter than the other. In contrast, in the case of the delayed fluorescence, an emission wavelength at the low temperature is longer than an emission wavelength at room temperature. This is because of the following reason: although light emission from a singlet is observed at room temperature, light emission occurs at the low temperature from the energy level of a triplet which is lower than that of the singlet. The term "emission wavelength" herein employed refers to the maximum emission wavelength or the emission start wavelength.

In addition, in the case of fluorescence which is not the delayed fluorescence, the emission lifetime is at a level of nanosecond because light emission occurs from a singlet. In the case of phosphorescence in which a triplet is involved in light emission, the emission lifetime is at a level of microsecond. In the case of the delayed fluorescence, the emission lifetime is at a level of microsecond because a triplet is involved in light emission. The delayed fluorescent material used in the present invention has an emission lifetime of 0.1 microsecond or more and less than 1 millisecond in a solid state or solution state.

With regard to the emission lifetime, the emission lifetime of each of the delayed fluorescence and phosphorescence is at a level of microsecond; in the case of the delayed fluorescence, however, the emission lifetime at a low temperature is much longer than the emission lifetime at room temperature. For example, when it is assumed that non-radiation deactivation is suppressed at a low temperature, in the case of a phosphorescent material having a quantum yield at room temperature of 0.1, the emission lifetime at the low temperature is at most ten times the emission lifetime at room temperature. In the case of the delayed fluorescent material, the emission lifetime strongly depends on temperatures because light emission occurs from different excited states at the low temperature and room temperature. Light emission occurs from a singlet at room temperature while light emission occurs from a triplet at the low temperature. Accordingly, the emission lifetime of the delayed fluorescent material at the low temperature is ten or more times the emission lifetime of the material at room temperature; depending on the kind of the material, it may be observed that the former is two or more orders of magnitude longer than the latter. The emission lifetime of the delayed fluorescent material used in the present invention shows the following characteristic when the material is in a solid state or solution state: an emission lifetime at the low temperature is 10 or more times, more specifically 50 or more times, or still more specifically 100 or more times the emission lifetime at room temperature.

In the case of phosphorescence, a non-radiation deactivation rate increases with increasing temperature, so that the emission intensity reduces. In contrast, in the case of the delayed fluorescence, the emission intensity increases with increasing temperature. This is because of the following reason: the probability in which intersystem crossing from a triplet to a singlet occurs increases by virtue of external temperature energy, so that a triplet exciton undergoes intersystem crossing to a singlet so as to be capable of easily emitting light.

The organic EL display apparatus according to the present invention has each of red (R), green (G), and blue (B) pixels placed in its plane. Each pixel has an organic EL device. The respective pixels are connected with one another through a data signal line for each pixel column, or are connected with one another through a scanning signal line for each pixel row.

Each pixel is connected to an organic EL device and to a TFT for controlling the luminance of the organic EL device.

The direction in which light is extracted may be of a bottom emission type in which light is extracted through a substrate having an organic EL device in its plane, or may be of a top emission type in which light is extracted not via a substrate.

The organic EL display apparatus according to the present invention is applicable to any embodiment with no limitation as long as the display apparatus is used in, for example, a display apparatus for a television or personal computer, or an instrument having a unit for displaying an image. For example, a portable display apparatus on which the display apparatus of the present invention is mounted is available. Alternatively, the display apparatus of the present invention can be used in the display unit of an electronic imaging device such as a digital camera or of a mobile phone.

In the present embodiment, the host material for the light-emitting layer may be, for example, CBP shown below (Chem 3).

The hole transport layer can be formed of, for example, PF01 shown below (Chem 4) having electron-donating property. The electron transport layer can be formed of, for example, Bphen shown below (Chem 5) having electron-accepting property.

In the present invention, the hole transport layer of the R pixel and the hole transport layer of the G pixel, which are formed using the same material, are preferably a common layer continuously formed extending over the R pixel and the G pixel.

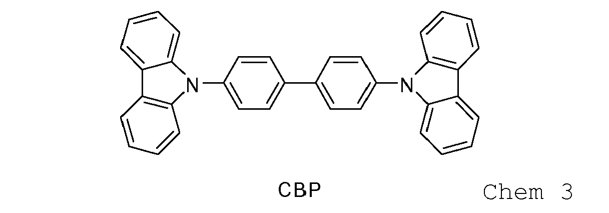

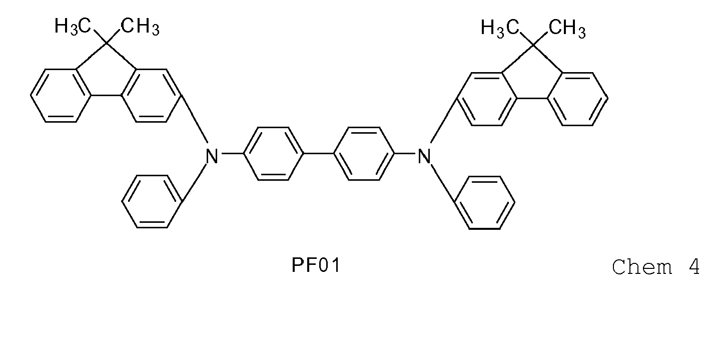

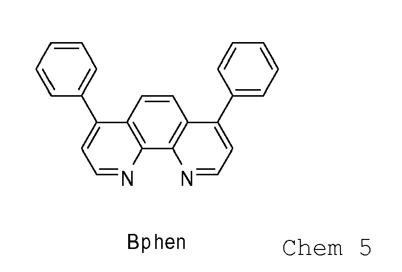

A fluorescent material rather than a phosphorescent material is preferably used as a guest for the light-emitting layer of the organic EL device that emits blue light from the viewpoint of a reduction in the drive voltage of the display apparatus.

### (Examples)

(Green color organic EL device 1)

A green color organic EL device 1 having the following constitution was produced.

Materials for, and the thicknesses of, the respective layers, and the order in which the layers are stacked are shown below.

ITO/PF01 (40 nm)/CBP (host material)+guest material (20 nm)/Bphen (50 nm)/KF (1 nm)/Al (100 nm)

An ITO film (120 nm) was formed on a non-alkali glass substrate having a thickness of 1.1 mm by a sputtering process, and the resultant was used as an anode side transparent electrode. PF01 shown in Chem 4 was formed into a film having a thickness of 40 nm to serve as a hole transport layer on the electrode by a vacuum evaporation process at a degree of vacuum of 3.0×10⁻⁵ Pa. Next, CBP shown in Chem 3 as a host material and the delayed fluorescent material shown in Chem 1 as a guest material were formed into a light-emitting layer having a thickness of 20 nm by a co-evaporation process under the following conditions: a ratio (concentration) of the guest material to the host material of 5 vol% and a degree of vacuum of 3.0×10⁻⁵ Pa.

Next, bathophenanthroline (Bphen) shown in Chem 5 was formed into a film having a thickness of 50 nm to serve as an electron transport layer by a vacuum evaporation process at a degree of vacuum of 3.0×10⁻⁵ Pa. Next, potassium fluoride (KF) was formed into a film having a thickness of 1 nm to serve as an electron injection layer by a vacuum evaporation process at a degree of vacuum of 2.0×10⁻⁴ Pa. Finally, Al as a cathode material was formed into a film having a thickness of 100 nm by a vacuum evaporation process at a degree of vacuum of 2.0×10⁻⁴ Pa. Thus, the organic EL device was obtained.

The organic EL device was evaluated by the following methods. A DC constant-current power source (manufactured by ADC CORPORATION, trade name: R6243) was used as a driving power source. A luminance meter (manufactured by TOPCON CORPORATION, trade name: BM-7 FAST) was used in luminance measurement. An instantaneous multi-photometric system (MCPD-7000 (trade name); manufactured by OTSUKA ELECTRONICS CO., LTD.) was used in CIE chromaticity measurement. The organic EL device produced in this example was evaluated for its values of CIE chromaticity, drive voltage, and emission efficiency at a luminance of 100 cd/m².

When the organic EL device produced in this example was caused to emit light at a luminance of 100 cd/m², the device emitted green light having CIE chromaticity coordinates of (0.33, 0.65). At that time, the device was driven at a voltage of 4.5 V, and the device showed an emission efficiency of 24 cd/A.

(Green color organic EL device 2)

In this example, an organic EL device was produced and evaluated by following the same procedure as in the green color organic EL device 1 with the exception that a delayed fluorescent material shown in Chem 6 below was used as a guest material in formation of the light-emitting layer in the green color organic EL device 1.

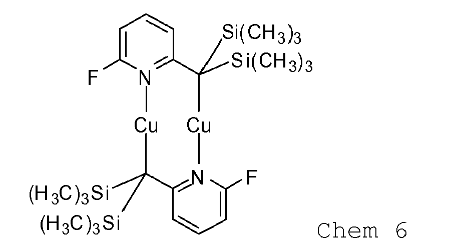

When the organic EL device produced in this example was caused to emit light at a luminance of 100 cd/m², the device emitted green light having CIE chromaticity coordinates of (0.32, 0.64). At that time, the device was driven at a voltage of 4.7 V, and the device showed an emission efficiency of 22 cd/A.

(Green color organic EL device 3)

In this example, an organic EL device was produced and evaluated by following the same procedure as in the green color organic EL device 1 with the exception that a delayed fluorescent material shown in Chem 7 below was used as a guest material in formation of the light-emitting layer in the green color organic EL device 1.

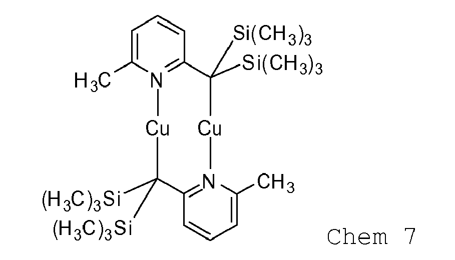

When the organic EL device produced in this example was caused to emit light at a luminance of 100 cd/m², the device emitted green light having CIE chromaticity coordinates of (0.32, 0.65). At that time, the device was driven at a voltage of 4.8 V, and the device showed an emission efficiency of 21 cd/A.

(Green color organic EL device 4)

In this example, an organic EL device was produced and evaluated by following the same procedure as in the green color organic EL device 1 with the exception that the delayed fluorescent material shown in Chem 2 above was used as a guest material in formation of the light-emitting layer in the green color organic EL device 1.

When the organic EL device produced in this example was caused to emit light at a luminance of 100 cd/m², the device emitted green light having CIE chromaticity coordinates of (0.33, 0.63). At that time, the device was driven at a voltage of 5 V, and the device showed an emission efficiency of 22 cd/A.

(Green color organic EL device 5)

In this example, an organic EL device was produced and evaluated by following the same procedure as in the green color organic EL device 1 with the exception that a delayed fluorescent material shown in Chem 8 below was used as a guest material in formation of the light-emitting layer in the green color organic EL device 1.

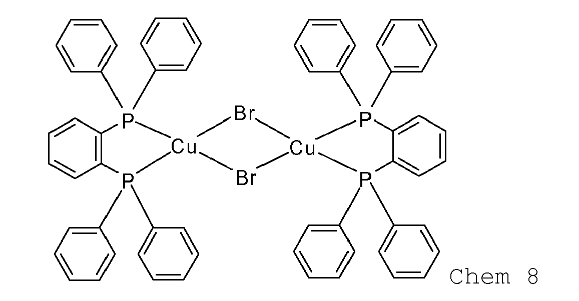

When the organic EL device produced in this example was caused to emit light at a luminance of 100 cd/m², the device emitted green light having CIE chromaticity coordinates of (0.34, 0.64). At that time, the device was driven at a voltage of 5.2 V, and the device showed an emission efficiency of 18 cd/A.

(Green color organic EL device 6)

In this example, an organic EL device was produced and evaluated by following the same procedure as in the green color organic EL device 1 with the exception that a delayed fluorescent material shown in Chem 9 below was used as a guest material in formation of the light-emitting layer in the green color organic EL device 1.

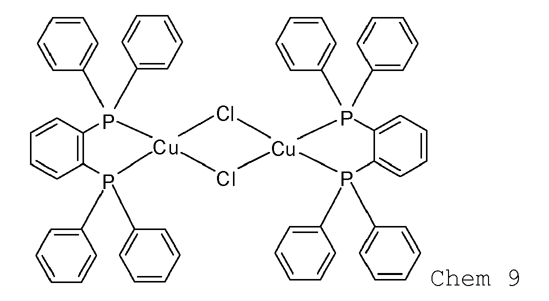

When the organic EL device produced in this example was caused to emit light at a luminance of 100 cd/m², the device emitted green light having CIE chromaticity coordinates of (0.33, 0.65). At that time, the device was driven at a voltage of 5.5 V, and the device showed an emission efficiency of 19 cd/A.

(Red color organic EL device 1)

In this example, an organic EL device was produced and evaluated by following the same procedure as in the green color organic EL device 1 with the exception that a phosphorescent material Ir(piq)₃ shown in Chem 10 below was used as a guest material in formation of the light-emitting layer in the green color organic EL device 1.

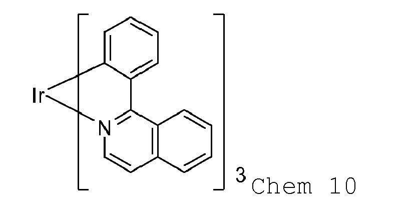

When the organic EL device produced in this example was caused to emit light at a luminance of 100 cd/m², the device emitted red light having CIE chromaticity coordinates of (0.66, 0.33). At that time, the device was driven at a voltage of 4.5 V, and the device showed an emission efficiency of 12 cd/A.

(Green color organic EL device 7)

In this example, which serves as a reference example, an organic EL device was produced and evaluated by following the same procedure as in the green color organic EL device 1 with the exception that a phosphorescent material Ir(ppy)₃ shown in Chem 11 below was used as a guest material in formation of the light-emitting layer in the green color organic EL device 1.

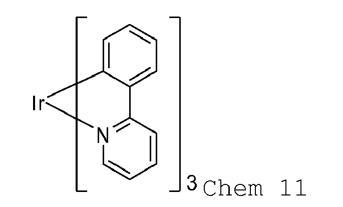

When the organic EL device produced in this example was caused to emit light at a luminance of 100 cd/m², the device emitted green light having CIE chromaticity coordinates of (0.35, 0.65). At that time, the device was driven at a voltage of 8 V, and the device showed an emission efficiency of 20 cd/A.

(Blue color organic EL device 1)

In this example, an organic EL device was produced and evaluated by following the same procedure as in the green color organic EL device 1 with the exception that a fluorescent material shown in Chem 12 below was used as a guest material in formation of the light-emitting layer in the green color organic EL device 1.

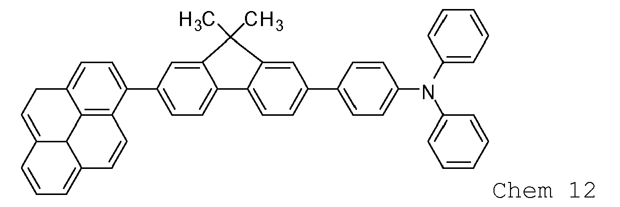

When the organic EL device produced in this example was caused to emit light at a luminance of 100 cd/m², the device emitted blue light having CIE chromaticity coordinates of (0.15, 0.13). At that time, the device was driven at a voltage of 5 V, and the device showed an emission efficiency of 2.5 cd/A.

(Organic EL display apparatus 1)

An organic EL display apparatus formed of three color pixels, i.e., R, G, and B pixels was produced by the following method. The display apparatus is of such a constitution that the R, G, and B pixels are arrayed in a matrix pattern. The display apparatus has a panel size of 3 inches in width across corners, and adopts a QVGA in which 240 pixels are arrayed in a longitudinal direction and 320 pixels are arrayed in a horizontal direction. The R, G, and B pixels each have an aperture ratio of 30%.

First, a TFT drive circuit including low-temperature polysilicon was formed on a glass substrate as a support member, and a planarizing film including an acrylic resin was formed on the circuit. ITO was formed and patterned into a transparent conductive film having a thickness of 120 nm on the film by a sputtering process. Furthermore, a device separation film was formed by using an acrylic resin. Thus, an anode side transparent electrode substrate was produced. The substrate was subjected to ultrasonic cleaning with isopropyl alcohol and washing with boiled isopropyl alcohol, and was then dried. After that, the substrate was subjected to UV/ozone cleaning, and then organic compounds and a cathode material were formed into films by vacuum evaporation. The formation of the films of an organic EL device from the organic compounds and the cathode material by vacuum evaporation was performed as follows: each R pixel was of the same constitution as that of the red color organic EL device 1, each G pixel was of the same constitution as that of the green color organic EL device 1, and each B pixel was of the same constitution as that of the blue color organic EL device 1. At the time of the film formation, the organic EL devices were separately deposited from the vapor onto the same substrate with a mask corresponding to an emission pattern so that the R, G, and B pixels might be arrayed in a matrix fashion in the plane of the substrate. Furthermore, silicon oxynitride was formed into a film having a thickness of 700 nm to serve as a protective film. Thus, the organic EL display apparatus was obtained. A power consumption upon display of a white W_{NTSC} (0.310, 0.316) on the organic EL display apparatus at 200 cd/m² was determined to be 400 mW.

(Organic EL display apparatus 2)

An organic EL display apparatus was produced by following the same procedure as in the organic EL display apparatus 1 with the exception that the formation of the films of an organic EL device in the organic EL display apparatus 1 was changed such that each G pixel was of the same constitution as that of the green color organic EL device 4. A power consumption upon display of a white W_{NTSC} (0.310, 0.316) on the organic EL display apparatus at 200 cd/m² was determined to be 410 mW.

(Organic EL display apparatus 3)

An organic EL display apparatus formed of three color pixels, i.e., R, G, and B pixels was produced by the following method.

In this example, the constitution of the lower electrode is different from that of the previous organic EL display apparatus 1. In addition, the constitution of the display apparatus is different from that of the previous organic EL display apparatus 1 in that the hole transport layer is common to the respective colors, that is, the same material is continuously provided extending over the pixels. In addition, the thickness of the light-emitting layer for each color is different from that of the previous organic EL display apparatus 1. In addition, the constitution of the display apparatus is different from that of the previous organic EL display apparatus 1 in that the electron transport layer is common to the respective colors, that is, the same material is continuously provided extending over the pixels. In addition, the constitution of the display apparatus is different from that of the previous organic EL display apparatus 1 in that the cathode as an upper electrode is common to the respective colors, that is, the same material is continuously provided extending over the pixels. The display apparatus is of the same constitution as that of the previous organic EL display apparatus 1 except the foregoing.

PF01 shown in Chem 4 was formed into a film having a thickness of 24 nm to serve as a hole transport layer by a vacuum evaporation process at a degree of vacuum of 3.0×10⁻⁵ Pa.

Next, light-emitting layers corresponding to the respective R, G, and B pixels were separately applied.

With regard to each R pixel, CBP shown in Chem 3 as a host material and the phosphorescent material Ir(piq)₃ shown in Chem 10 as a guest material were formed into a light-emitting layer having a thickness of 100 nm by a co-evaporation process under the conditions of a ratio (concentration) of the guest material to the host material of 5 vol% and a degree of vacuum of 3.0×10⁻⁵ Pa.

With regard to each G pixel, CBP shown in Chem 3 as a host material and the delayed fluorescent material shown in Chem 1 as a guest material were formed into a light-emitting layer having a thickness of 65 nm by a co-evaporation process under the conditions of a ratio (concentration) of the guest material to the host material of 5 vol% and a degree of vacuum of 3.0×10⁻⁵ Pa.

With regard to each B pixel, CBP shown in Chem 3 as a host material and the fluorescent material shown in Chem 12 as a guest material were formed into a light-emitting layer having a thickness of 40 nm by a co-evaporation process under the conditions of a ratio (concentration) of the guest material to the host material of 5 vol% and a degree of vacuum of 3.0×10⁻⁵ Pa.

Next, bathophenanthroline (Bphen) shown in Chem 5 was formed into a film having a thickness of 10 nm to serve as an electron transport layer by a vacuum evaporation degree at a degree of vacuum of 3.0×10⁻⁵ Pa.

Furthermore, Bphen and CS₂CO₃ were formed into a film having a thickness of 14 nm to serve as an electron transport layer by co-evaporation (at a weight ratio of 9:1) at a degree of vacuum of 2.0×10⁻⁴ Pa.

Silver (Ag) was formed into a film having a thickness of 15 nm to serve as the cathode by a vacuum evaporation process at a degree of vacuum of 2.0×10⁻⁴ Pa.

In this example, the reflection interface is an interface between the reflective electrode and the transparent conductive film in the lower electrode, the emission interface is the center of the light-emitting layer, and the refractive index of the hole transport layer and the light-emitting layer is 1.5. In view of the fact that the emission wavelengths of the R, G, and B pixels are 620 nm, 520 nm, and 445 nm, respectively, the thicknesses of the respective R, G, and B pixels are set such that light beams emitted from the pixels enhance one another through interference, and hence the chromaticity of a color displayed on the apparatus by the pixels and the efficiency with which the apparatus displays the color are improved.

A power consumption when displaying a white W_{NTSC} (0.310, 0.316) on the organic EL display apparatus at 200 cd/m² was determined to be 400 mW.

(Comparative Example 1)

An organic EL display apparatus was produced by following the same procedure as in the organic EL display apparatus 1 with the exception that the formation of the films of an organic EL device in the organic EL display apparatus 1 was changed such that each G pixel was of the same constitution as that of the green color organic EL device 7. A power consumption when displaying a white W_{NTSC} (0.310, 0.316) on the organic EL display apparatus at 200 cd/m² was determined to be 800 mW.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions. Provided is an organic EL display apparatus which can be driven at a low voltage and in which a red-light-emitting device uses a phosphorescent material, a green-light-emitting device uses a delayed fluorescent material, and the same material is used in the hole transport layers of the respective devices.

## Claims

1. An organic EL display apparatus, comprising:
an organic EL device that emits red light as a first pixel;
an organic EL device that emits green light as a second pixel; and
an organic EL device that emits blue light as a third pixel,
wherein:
the organic EL device that emits red light comprises a host material and a phosphorescent material as a guest material in its light-emitting layer;
the organic EL device that emits green light comprises a host material and a delayed fluorescent material as a guest material in its light-emitting layer; and
a hole transport layer of the organic EL device that emits red light and a hole transport layer of the organic EL device that emits green light comprise the same material.

2. The organic EL display apparatus according to claim 1, wherein the hole transport layer of the organic EL device that emits red light and the hole transport layer of the organic EL device that emits green light are continuously disposed.

3. The organic EL display apparatus according to claim 2, wherein the delayed fluorescent material comprises one of compounds represented by the following structural formulae:

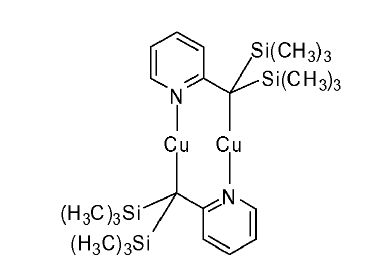

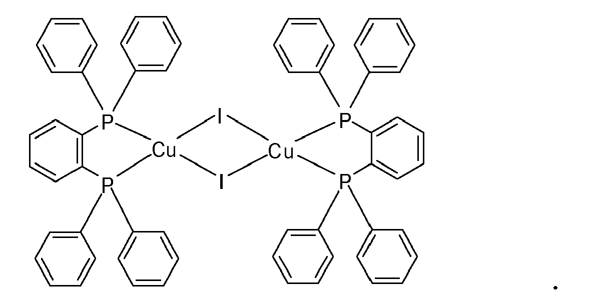

4. The organic EL display apparatus according to claim 3, wherein the phosphorescent material comprises a compound represented by the following structural formula:
